# EUROPEAN PATENT APPLICATION

(11) **EP 1 892 767 A1**
(43) Date of publication of application: **27.02.2008**
(21) Application number: 06380233.4
(22) Date of filing: 22.08.2006
(51) Int. Cl.: H01L 31/0224, H01L 31/068

(54) **Photovoltaic cell and production thereof**

(71) Applicant: BP Solar Espana, S.A. Unipersonal, 28760 Madrid (ES)
(72) Inventor: Fernandez, Juan Manuel, 28760 Tres Cantos (Madid) (ES); Bueno, Rafael, Madrid 28860 (ES); Morilla, Carmen, 28760 Tres Cantos (Madid) (ES); Vincueria, Ines, 28760 Tres Cantos (Madid) (ES)
(74) Representative: Hamer, Christopher K.

(57) **Abstract**

A process for producing a photovoltaic device having a substrate comprising silicon doped with a first dopant, the process comprising the steps of:
a. forming a first layer over a front surface of the substrate, the first layer comprising a second dopant of a conductivity type opposite the first dopant;
b. forming a second surface coating over the first layer;
c. forming elongate grooves reaching or entering the silicon substrate;
d. forming a third layer within the grooves, the layer comprising a third dopant of a conductivity type opposite to the first dopant;
e. forming a contact finger system which intersects with the grooves to provide an electrically conducting front contact; and
f. forming a second contact.

## Description

### Background of the Invention

The present invention relates to photovoltaic devices, particularly photovoltaic devices comprising thin layers of semiconductor materials, such as thin layers of monocrystalline or multicrystalline silicon. More particularly, the present invention relates to photovoltaic devices comprising monocrystalline or multicrystalline silicon semiconductor materials.

The photovoltaic devices, also known as photovoltaic cells, are used to convert light energy into electrical energy. Photovoltaic cells can be used to generate energy (solar cells) or they can be used as photodetector elements in other devices. Photovoltaic cells are a source of renewable energy. However their use is limited by their electrical output. Typically, many photovoltaic cells are arranged in one or more panels or modules in order to generate sufficient power required for a desired commercial or consumer application.

Photovoltaic cells having greater efficiency result in modules with greater electrical power output. Therefore, it is necessary to be able produce a large number of highly efficient photovoltaic cells. It would be very desirable to be able to reduce the manufacturing cost, increase the efficiency of light conversion, or both, of such photovoltaic devices. The photovoltaic cells of this invention are highly efficient in comparison to conventionally produced cells.

Most photovoltaic cells are fabricated from either monocrystalline silicon or multicrystalline silicon. Silicon is generally used because it is readily available at a reasonable cost due to its use in the microelectronics industry and because it has the proper balance of electrical, physical and chemical properties for use to fabricate photovoltaic cells. During the manufacture of photovoltaic cells, silicon is doped with a dopant of either positive or negative conductivity type, and is typically cut into thin substrates, usually in the form of wafers or ribbons, by various methods known in the art. Throughout this application, the surface of the substrate, such as a wafer, intended to face incident light is designated as the front surface and the surface opposite the front surface is referred to as the back surface. By convention, positive conductivity type is commonly designated as "p" and negative conductivity type is designated as "n." In this application, "p" and "n" are used only to indicate opposing conductivity types. In this application, "p" and "n" mean positive and negative respectively but can also mean negative and positive respectively.

The key to the operation of a photovoltaic cell is the creation of a p-n junction, usually formed by further doping the front surface of the silicon substrate to form a layer of opposite conductivity type from the doped silicon substrate. Such a layer is commonly referred to as the emitter layer. In the case of a p-doped substrate, the emitter layer is formed by doping the front surface with an n-type dopant. The p-n junction is the interface between the p-doped region and the n-doped region.

Light entering these solar cells is absorbed, thereby generating electron-hole pairs, which, if of sufficient diffusion length, are then spatially separated by the electric field produced by the solar cell junction and are collected at respective top and bottom surfaces of the solar cell. For example, in an n-p type solar cell electrons will travel to the top surface where they will then be collected by a metallic grid positioned thereon. The metallic grid may typically comprise a number of metallic fingers separated along the top surface by a relatively large distance and connected to each other by a common bus bar. The electrons will travel either directly to the metallic fingers or approach the top surface between the fingers and then travel along the surface of the solar cell until they can be collected by one of the fingers. Holes, on the other hand, will travel to the bottom surface of the solar cell where they may be collected by a metallic sheet covering the entire bottom surface.

U.S. Patent No. 3,811,954 describes a solar cell with improved efficiency in the short wavelength, i.e. blue-violet portion of the spectrum corresponding to 0.3-0.5 microns, thereby sharply increasing output power. The alleged improvement was accomplished by reducing the junction depth and, providing a very fine geometric pattern metallic electrode on the light-incident surface of the solar cell. The junction depth is typically between 500 Å and 2,000 Å, and the metallic fingers of the fine geometric electrode are typically spaced on the order of only a few hundredths of a centimeter. The resultant fine geometric pattern electrode generally covers, and is in ohmic contact with between 5 to 10% of the surface area of the solar cell and prevents the covered area from converting incident photons to electrical energy. The surface area of the cell which is not in contact with the electrode, is covered by a metal oxide anti-reflective coating.

Reverse currents in silicon solar cells comprise the flow of electrons and holes to the junction where they recombine. This current degrades the performance of the cell, i.e. the I-V characteristic, by opposing a part of the primary current flow across the diode. Reverse currents, which typically have been considered in solar cell models result from the bulk and space charge regions of semiconductors. Another source of reverse current is the top surface layer where impurities are centers of recombination as well as sources of thermally generated electron-hole pairs. However, this current is generally neglected in the standard solar cell since there is a high concentration of impurities, which act to produce a minimum of electron-hole pairs that recombine at the junction. Furthermore, a thick "dead layer" isolates the surface generation centers in the top layer of the solar cell and also any effect from the ohmic contact with the metallic electrode.

In the solar cell according to U.S. 3,811,954, the shallow junction results in a minimization of the dead layer, which exists at the light-incident surface of the normal silicon cell. Furthermore, the density of impurities diffused into the top layer of the cell is decreased and provides sources for a significant reverse current flow. The ohmic contact formed between the metallic electrode and the top layer of the silicon solar cell causes thermal generation of currents to occur near the surface of the solar cell. The metallic contact acts as a large sink for recombination and also as a large source for generation of electron-hole pairs.

The front contacts of such cells are typically deposited as an open grid pattern to allow light to be absorbed by the exposed silicon surface. In an improvement to the design disclosed in U.S. 3,811,954 above, it has been proposed that the front grid be deposited in embedded grooves to reduce grid-shading losses. This type of solar cell is often known as a Buried Contact solar cell (also referred to as a Laser Grooved Buried Grid - LGBG solar cell). The basic cell is disclosed in EP 156366, and the process for fabricating such a cell typically includes the following steps:
1) in the case of monocrystalline silicon wafers with [100] crystal orientation, etching of the silicon surface in a caustic solution to form random pyramids;
2) doping the top surface of a p-type silicon wafer with a Group V element, typically phosphorus, to produce the n⁺ layer;
3) adding a top surface coating of silicon nitride, to act as an antireflection layer and also as a dielectric (non-conducting) layer in order to prevent metal plating on unwanted regions of the top surface;
4) cutting grooves into the surface of the wafer into which metal will be plated. The grooves are typically cut using a laser but may be chemically etched, plasma etched, or mechanically formed using a diamond saw;
5) doping the exposed p-type silicon surface in the grooves with an n-type Group V element, typically phosphorus;
6) treating the cell to provide a back surface field (BSF), by doping the rear surface with an electron "acceptor" such as aluminium or boron;
7) plating metal contacts into the grooves to provide an electrically conducting front contact, and also simultaneously into the rear surface in order to provide an electrically conducting back contact.

Following the above steps, it is usually necessary to electrically isolate the edges of the wafer.

However, such a method suffers from a number of drawbacks. The process requires a layer of electroless nickel to be deposited in the grooves, and the rear surface of the wafer, followed by sintering, and a likely step of further deposition of metal (for example, nickel, copper and/or silver). Current production technologies providing required manufacturing yields add excessive cost in terms of raw material consumption and long cycle time to the process for preparing the solar cell.

In addition, a problem associated with the electroless plating process is that it prevents the formation of a uniform well defined back-surface field, and the benefits associated therewith. Conversely, achieving a uniform well defined back surface field, such as using thick Aluminum films in the rear, would result in poor metallization yield which in turn affects detrimentally the performance of the solar cell.

The inventors of the present invention have surprisingly found that the benefits of using a deep groove grid, can be combined with that of reduced surface metal contacts, to produce an alternative photovoltaic cell having good efficiency, and good absorption in both the blue-violet portion of the spectrum and the red-infared portion.

### Summary of the invention

According to the present invention, there is provided a process for producing a photovoltaic device having a substrate comprising silicon doped with a first dopant, the process comprising the steps of:
(a) forming a first layer over a front surface of the substrate, the first layer comprising a second dopant of a conductivity type opposite the first dopant;
(b) forming a second surface coating over the first layer;
(c) forming a plurality of elongate grooves in a front surface of the device, such that the grooves reach or enter the silicon substrate;
(d) forming a third layer within the groove, the layer comprising a third dopant of a conductivity type opposite the first dopant;
(e) forming a contact finger system which intersects with the grooves to provide an electrically conducting front contact; and
(f) forming a second electrically conducting contact.

The silicon substrate is typically obtained by slicing silicon ingots, vapor phase deposition, liquid phase epitaxy or other known methods. Slicing can be via inner-diameter blade, continuous wire or other known sawing methods. Although the substrate can be cut into any generally flat shape, for the case of monocrystalline wafers they are typically circular or pseudo-square in shape. By "pseudo-square," is meant a predominantly square shape, usually with rounded corners. Substrates, typically in the form of a wafer, of this invention are typically less than about 300 micrometers thick. Substrates of this invention can be less than about 200 micrometers thick, preferably less than 150 micrometers thick, more preferably less than 100 micrometers thick, and most preferably less than 50 micrometers thick. Typically, they are between about 150 micrometers and 250 micrometers thick. Circular and pseudo-square substrates are typically cut from a cylindrical silicon block having a diameter in the range of, but not limited to, 100 mm to 200 mm.

The substrate is preferably a p-type silicon, which has been doped using a p-type dopant. Examples of such dopants include boron, gallium and indium, and more preferably boron. One or more layers of additional material, for example, germanium, may also be disposed over the substrate surface.

Preferably, the substrate is textured and/or cleaned prior to step (a). The substrate is usually cleaned to remove any surface debris and cutting damage. Typically, this includes placing the substrate in a wet chemical bath; for example, a solution comprising any one of a base and peroxide mixture, an acid and peroxide mixture, a NaOH solution, or several other solutions known and used in the art. In one preferred embodiment, the solution comprises HF/HCl. The temperature and time required depends on the specific solution used, for example, a 25 wt% to 35 wt% aqueous NaOH solution can be used at a temperature in the range of about 75 to 95 °C for about 20 to about 70 seconds.

Optionally (especially for monocrystalline substrates), the substrate can also be texturized by, for example, anisotropic etching of the crystallographic planes. Texturing is commonly in the form of pyramid-shapes depressed or projected from the substrate surface. The height or depth of the pyramid-shapes is typically from about 4 to about 7 micrometers. For a typical <100> orientation substrate, a low concentration aqueous NaOH solution at elevated temperature can be used to anisotropically etch the <100> plane revealing the <111> plane in pyramid-shape projections. As used in this application, a "low concentration" solution means, preferably, a concentration of solute less than about 7 wt%. "Elevated temperature" as used herein means preferably, a temperature greater than about 80 °C. Under such conditions, for example, a substrate would be placed in the solution for about 10 to about 30 minutes. In a preferred embodiment, a NaOH/IPA (2%/2%) alkaline solution is used.

The first layer is preferably formed by doping the substrate with a n-type dopant. N-doping can be accomplished by depositing the n-dopant onto the substrate and then heating the substrate to "drive" the n-dopant into the substrate and then heating the substrate to "drive" the n-dopant into the substrate. Gaseous diffusion (for example, POCl₃ horizontal tube diffusion, including temperatures of from 700 to 1000°C, preferably 800 to 900°C) can be used to deposit the n-dopant onto the substrate surface. However, other methods can also be used, such as ion implantation, solid state diffusion, spin-on dopant sources, or other methods used in the art to create an n-doped layer and a shallow p-n junction proximal to the substrate surface.

Suitable n-dopants include Group V elements, preferably phosphorus, but any suitable n-dopants can be used alone or in combination, such as arsenic, antimony or lithium. Typically, a plurality of substrates are placed in a tray such that the front (and sometimes back) surface and the edges of the substrate are exposed to the n-dopant. Using this method, an emitter layer and p-n junction created in the n-doping process are formed along all of the surfaces of the substrate.

The depth of the n-doped layer at the front surface is typically greater than about 0.1 micrometers, preferably greater than about 0.2 micrometers and is typically less than about 0.5 micrometers, preferably less than about 0.3 micrometers. The surface dopant concentration of the emitter layer at the front surface is preferably greater than about 10¹⁸ atoms/cm³, more preferably greater than about 10¹⁹ atoms/cm³. The surface dopant concentration of the emitter layer at the front surface can be as high as saturation, but is typically less than about 10²² atoms/cm³, more preferably less than about 10²¹ atoms/cm³, most preferably the surface dopant concentration of the emitter layer is about 10²⁰ atoms/cm³. The n-doping process typically creates a layer of silicon oxide on the surfaces of the wafer. The silicon oxide can function as an antireflective coating and as a surface passivator. However, the silicon oxide layer may be removed in favor of the second surface coating, for example silicon nitride. The silicon oxide can be removed through, for example, chemical etching in a wet chemical bath, typically a low concentration HF solution at ambient temperature for about 10 to about 40 seconds.

The second surface coating is applied after the creation of the emitter layer and is disposed over the first layer at the front surface and preferably the edge surface, and more preferably over the edge surface and the periphery of the back surface. The surface coating masks the front surface, preferably the edges, and more preferably the edges and the periphery of the back surface, and preferably serves one or more of the following functions: dielectric layer, anti-reflective coating, surface passivation, bulk passivation, diffusion mask and metallization diffusion barrier. Silicon nitride is preferred as a surface coating because it can function as: an effective diffusion mask; an effective metallization diffusion barrier; an anti-reftective coating; provide surface passivation and provide bulk passivation. Preferably hydrogen is trapped in such a silicon nitride surface coating. However, the surface coating may be any coating, film or combinations of coatings and/or films, which can function as a mask and, preferably serves one or more of the above functions. Other possible substances that can be used as a surface coating include tantalum oxide, silicon dioxide, and titanium oxide. Combination of any such coatings, films and dielectrics can also be used as a surface coating.

The second surface coating is typically applied using plasma enhanced or low pressure chemical vapor deposition (PECVD & LPCVD respectively) or other techniques known in the art, such as atmospheric chemical vapor deposition (APCVD), thermal oxidation, screen printing of pastes, inks or sol gel, etc. LPCVD is especially preferred (particularly where silicon nitride is used to form the second surface coating). The coating is applied so that it is disposed over the front surface and preferably the edges of the substrate preferably by placing the back surface of the substrate against a plate. This may be accomplished by placing a plurality of substrates horizontally on a tray or plate. Substrates can also be placed vertically or at an angle such that the back surface is against a flat surface; for example, a graphite plate. The back surface of the substrate remains free or substantially free of the surface coating. By "substantially free of the surface coating" is meant that surface coating disposed over the back surface is limited to the periphery of the back surface, for example less than about 5 mm from an edge of the substrate. As noted above, the second surface coating disposed over the front surface of the substrate is preferably silicon nitride, and may be applied by low pressure chemical vapour deposition using dichlorosilane and ammonia gases (preferably at a temperature of 800 to 900°C). This deposition technique results in a second coating with the required film characteristics needed to realize an especially preferred embodiment of the present invention, which embodiment utilizes much more of the potential of this invention.

in general, the second surface layer is preferably greater than about 65 nanometers, more preferably greater than about 70 nanometers, most preferably, greater than about 72 nanometers, and preferably less than about 120 nanometers, more preferably less than 100 nanometers, most preferably less than about 77 nanometers thick.

Preferably, after step (b), any second surface coating on the edges and rear surface is removed. The excess material is preferably removed by means of dry plasma etching or alternative techniques. The process generally requires adequate physical masking of the front surface while exposing the full back of the cell to the dry plasma environment. In an embodiment of this process, cells are slotted face to face into inert carriers so that the plasma chemistry can effectively react with the back of the cells, thereby removing excess material from the second coating that might have reached the back of the cell. This process is preferably performed via the generation of an RF (13,6 MHz) plasma using a mix of Freon 14 (CF₄), with oxygen (O₂), and or nitrogen (N₂) in a ratio which depends on the chamber and load geometries. However, any etching technique capable of removing excess material can be used, so long as substantial degradation of the surface coating does not occur. By "without substantial degradation" is meant that the surface coating remains disposed over the front face.

The grooves formed in step (c) are preferably parallel and scribed into the silicon substrate by means, preferably of a laser. The grooves are typically 10 to 40µm wide, preferably 15 to 35µm and most preferably 20 to 30µm. The grooves are typically 20 to 60µm deep, preferably 25 to 45µm and most preferably 30 to 40µm. In addition the grooves are typically 0.5 to 4.0mm apart, preferably 0.75 to 3.0mm and most preferably 1.0 to 2.0mm.

The grooves are preferably formed using a laser, but may also be formed by mechanical means such as scratching and chemical etching. Laser grooved samples may be prepared, for instance, by means of an 8W 1064 nm Nd:Vanadate laser switched at approximately 150 kHz with pulse durations around 130 ns capable of focused spot sizes of approximately 10 µm. The silicon substrates are preferably held on x-y stages capable of realizing well defined, and uniform, grooves along their lengths. Alternatively, grooves can also be formed via scanning mirror optics using equivalent laser sources. Mechanical scribing, screen print patterning via etchant dispensing or alternative techniques may also be used to provide sufficient openings in the second coating which would be suitable for producing solar cells in accordance with the present invention. The resulting grooves are preferably of uniform dimensions along their length for optimal performance. The grooves may be continuous or discontinuous, provided that good groove metallization contact can still be made.

Preferably after step (c) the grooves may be cleaned as the action of forming the grooves generally results in the formation of silicon particles, and undesirable crystal imperfections. The cleaning is generally accomplished by placing the substrate in a chemical bath (containing for example, NaOH or HF). The type of chemical used, the temperature of the bath and the time the substrate is kept in the bath are dependant upon the material used for the substrate. For example, a 30 wt% aqueous NaOH bath at a temperature in the range of from about 80°C to about 92°C can be used for either monocrystalline or multicrystalline silicon. A monocrystalline silicon substrate would be exposed, for example, to the bath for about 80 seconds to about 100 seconds. A multicrystalline silicon substrate would generally be exposed to the bath for a longer period of time, for example, at least about 3 minutes and up to, for example, about 10 minutes. Preferably, the grooves are cleaned using a NaOH solution, and more preferably a 12% NaOH solution.

Preferably, after the initial cleaning step above, the device may be further cleaned by subsequent immersions in hydrofluoric acid and hydrochloric acid with immediate and final rinsing in deionized water followed by drying.

The cleaning steps detailed above, may also be used to polish the back surface of the device. Back surface etching results in an untextured or substantially smooth back surface. As used herein, "substantially smooth" back surface preferably means that the back surface is untextured. "Untextured" as used herein, preferably means the absence of peaks or valleys on the substrate surface; for example, the absence of anisotropic etch surface topography or, as (further example, having a surface topography consistent with isotropic etching.

If applicable, back surface etching also results in a back surface which is free, or substantially free, of n-dopant, and free or substantially free of a p-n junction. As used herein, "substantially free of n-dopant" preferably means that the n-dopant has been etched from the back surface except that n-dopant may still be present at the portion of the back surface over which a surface coating is disposed. After etching, some n-dopant can be present in any unmasked regions of the back surface at a substantially reduced surface concentration; for example, a surface concentration less than about 10¹⁵ atoms/cm³, preferably less than about 10¹³ atoms/cm³, more preferably less than about 10¹¹ atoms/cm³. As used herein, "substantially free of a p-n junction proximal to the back surface" means that the p-n junction proximal to the portion of the back surface over which the surface coating is not disposed is removed or rendered ineffective due to a decreased concentration of n-dopant, for example, a back surface concentration of n-dopant less than about 10¹⁵ atoms/cm³, preferably less than about 10¹³ atoms/cm³, more preferably less than about 10¹¹ atoms/cm³, where the "atoms" are the atoms of dopant.

The step (d) of forming a third layer of material is carried out as for step (a) above, and in addition to forming a layer within the groove may also form about the edges and rear surface of the substrate. The formation of the third layer within the groove forms what is known as a heavily doped layer (sometimes designated n++) by virtue of process conditions, which if altered relative to step (a) above, result in a heavily doped layer. Such process conditions include the driving in at elevated temperatures (ca. 950 to 1000 °C) of the doping element such that both the surface concentration of the dopant element, and the extent of it into the substrate material, is higher than in step (a). Surface concentrations in excess of 10¹⁹ cm⁻³ extending into the material in excess of 5µm are typical.

An important consequence of this process step is the effect that such heavy dopant diffusion has on the diffusion length of the photogenerated carriers. Such diffusion is known to produce an impurity gettering effect in which impurities in the bulk of the substrate material are electrically neutralised by the injection of crystal defects during the diffusion process. These defects generate stress fields in the material, which are effective neutralization centers for unwanted impurities in the bulk of the substrates. Minority carrier diffusion lengths in excess of 250µm can be achieved by virtue of the gettering effect during formation of the third layer. The preferred conditions for incorporating this process into the cell fabrication sequence, is achieved by single slotting the substrates in inert carriers during the process step.

Preferably after step (d), excess amounts of the byproduct film produced during deposition of the third layer material (i.e. present after step (d)) are removed. Processes similar to those described above for removal of excess material from step (b) may be used. Preferably, a solution of 1% to 4% HF is used, and afterwards the device rinsed using deionized water.

Typically, contacts are in the form of a conductive metal placed on or into the front and back surfaces. The contacts can be created using photolithographic methods, by laser grooving and electroless plating methods, screen printing, or any other method that provides good ohmic contact with the front and back surfaces such that electric current can be drawn from the photovoltaic cell. Typically, the contacts are present in a design or pattern, for example a grid, fingers, lines, etc. The contacts are preferably screen printed onto the substrate using a conductive metal paste; for example, a silver paste. The contacts are typically screen printed onto the surface and allowed to dry. After applying the contacts, the substrate may be fired, typically at a temperature of from about 800 to about 950°C to anneal the contacts to the substrate. Methods for adding contacts to a wafer substrate for a photovoltaic cell are well known in the art. An important factor in the success of this invention is the avoidance of ohmic contact formation under undesired regions of the screen printed front metallization, which prevents excessive carrier recombination under the metallization. This is most preferably achieved via optimisation of the LPCVD deposited second surface and firing conditions of the screen printed front metallization pattern.

Preferably, the contact fingers intersect at an angle of from 45 to 90°, preferably from 60 to 90°, more preferably from 80 to 90° and most preferably at 90° (i.e. are orthogonal to each other).

Preferably, the process of this invention [and more specifically step (f)] includes the formation of an improved back surface field to increase the infrared and far infrared efficiency of the photovoltaic cell. A back surface field is preferably formed contemporaneously with the forming of the back contacts. However, it can be formed either before or after forming the back contacts. A back surface field can be generated by forming a p+ layer on at least a portion of the back surface of the substrate. A p+ layer is a layer heavily doped with a p-type substance. By "heavily doped" we mean, preferably, that the doping is substantially greater doping than the p-doping of the substrate. The depth of the layer is typically equal to or less than the depth of the emitter layer and preferably less than about 0.5 micrometers, more preferably less than about 0.3 micrometers; and is preferably greater than about 0.1 micrometers, more preferably greater than about 0.2 micrometers in depth. The peak doping concentration of the p+ layer is advantageously greater than about 10¹⁷ atoms/cm³, preferably greater than about 10¹⁸ atoms/cm³. The p+ doping concentration can be as great as the saturation point; However, it is preferably less than about 10²⁰ atoms/cm³, more preferably less than about 10¹⁹ atoms/cm³, where the "atoms" are atoms of dopant.

The p+ layer is advantageously formed by, alloying a substance into the back surface of the substrate. Aluminium is typically used but any substance can be used which is capable of alloying with the substrate and resulting in a p+ layer. Aluminium, or another alloying substance such as, for example, boron, gallium or indium, is deposited onto the back surface of the substrate. The aluminium or other alloying substance is preferably applied using screen printing techniques. Methods for screen printing materials such as pastes are, as stated above, well known in the art. The substrate is then fired at a temperature sufficient to alloy the aluminium, or other substance as mentioned above, used to form a p+ layer to the silicon wafer substrate, preferably at a temperature of about 800 to about 950°C, thereby creating a back surface field. In one embodiment of this invention, the rear contacts are screen printed onto the substrate followed by screen printing of aluminium onto the back surface of the substrate and subsequent drying and cofiring. Preferably, the aluminium is limited to portions of the back surface not covered by the back contact.

Generally, after formation of the substrate, the edges of the wafer are electronically isolated.

In a further embodiment of the present invention, the step (a) may be excluded from the method defined. In such an embodiment, the "first layer" may be formed at the same time as the third layer in step (d). More specifically, during step (d) the "first layer" may be formed by means of dopant diffusion thought the second surface coating.

The processes of the present invention avoid the need for oxidation of the top surface of the substrate (following diffusion of dopant) as is found in many prior art processes. This is particularly advantageous as time (and therefore money) can be saved using the processes of the present invention, without a reduction in the efficiency of the solar cells produced. It will be appreciated that when such an oxidation step is used, it is also necessary in a later process step, to remove the diffusion oxide which has been produced, thus requiring yet another step in the formation of the solar cell.

The present invention is also directed to photovoltaic devices produced in accordance with the methods of the present invention.

A further improved embodiment of the present invention assures that the back surface of the cell is free or substantially free of any n-dopant. Prior art cells utilizing back surface fields alloy a compound, typically aluminium, through an n-doped layer on the back surface and into the silicon substrate. The n-dopant compound is not removed, and therefore the efficacy of the resulting back surface field is reduced compared to a cell utilizing the same alloying process but having a back surface which is free or substantially free of n-dopant. Removal of the back n-doped layer increases the effectiveness of the back surface field and increases the efficiency of the resulting photovoltaic cell.

A further advantage of the photovoltaic cells of this invention is that the back surface is preferably substantially smooth as opposed to textured. The efficiency of photovoltaic cells is improved by front surface texturing. However, texturing typically occurs on both the front and back surfaces of a substrate. It is well known that a substantially smooth, untextured back surface results in better back surface passivation. The process of this invention removes texturing on the back surface and provides the advantageous substantially smooth or untextured back surface qualities.

Still further, the present invention encompasses a photovoltaic device comprising:
(a) a first layer formed over a front surface of the substrate, the first layer comprising a second dopant of a conductivity type opposite the first dopant;
(b) a second surface coating formed over the first layer;
(c) a plurality of elongate grooves formed in a front surface of the device, such that the grooves reach or enter the silicon substrate;
(d) a third layer formed within the grooves, the layer comprising a third dopant of a conductivity type opposite the first dopant;
(e) 3 contact finger system which intersects with the groove to provide an electrically conducting front contact; and
(f) a second contact.

The present invention will now be discussed by way of example, and with reference to the accompanying drawings in which:
Figure 1 is a diagrammatic view of a substrate in accordance with the present invention;
Figure 2 is a plan view of the substrate of Figure 1;
Figure 3 is a diagrammatic view of the substrate of Figure 1, having a first layer and second surface coating formed thereon;
Figure 4 is a plan view of the substrate of Figure 3;
Figure 5 is a diagrammatic view of the substrate of Figure 3, which has been cleaned and excess second surface coating removed;
Figure 6 is a plan view of the substrate of Figure 5;
Figure 7 is a diagrammatic view of the substrate of Figure 5 after the formation of grooves therein;
Figure 8 is a plan view of the substrate of Figure 7;
Figure 9 is a diagrammatic view of the substrate of Figure 7 after groove formation and subsequent cleaning;
Figure 10 is a plan view of the substrate of Figure 9;
Figure 11 is a diagrammatic view of the substrate after formation of a third layer within the grooves;
Figure 12 is a plan view of the substrate of Figure 11;
Figure 13 is a diagrammatic view of the substrate of Figure 11 wherein intersecting contacts have been formed with the grooves;
Figure 14 is a plan view of the substrate of Figure 13;

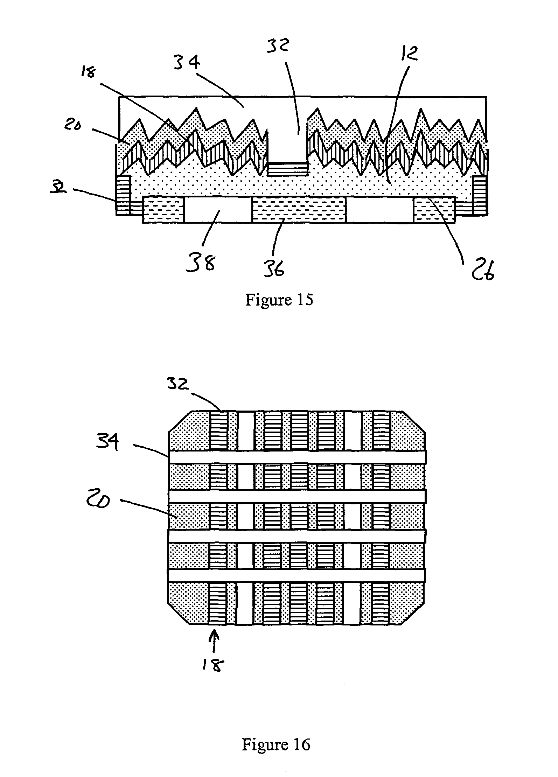

Figure 15 is a diagrammatic view of the substrate of Figure 13 after formation of a rear contact;
Figure 16 is a plan view of the substrate of Figure 15;

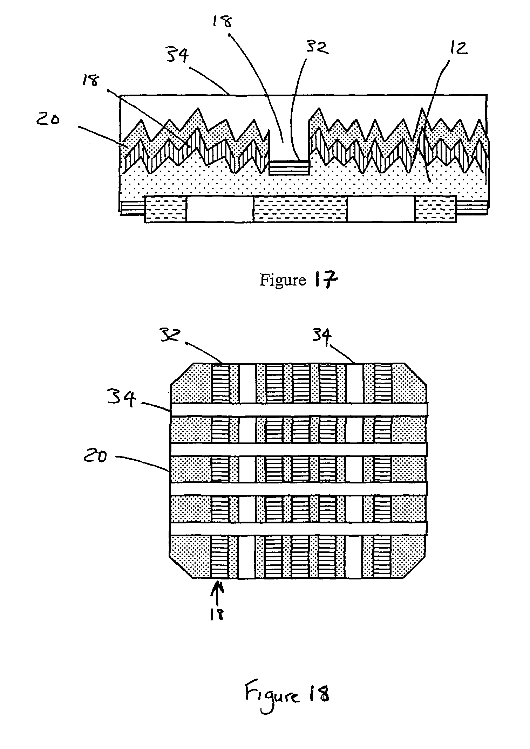

Figure 17 is a diagrammatic view of the substrate of Figure 18 after isolation of the edge junctions; and
Figure 18 is a plan view of the substrate of Figure 17.

### General Example

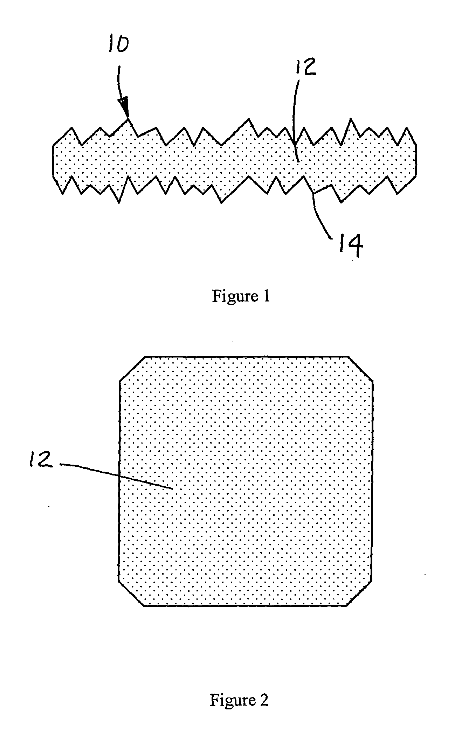

Figure 1 shows a cross-section of a cell 10 in accordance with an embodiment of this invention. The photovoltaic cell 10 comprises a textured substrate, for example p-doped with boron,12. The texture is symbolically depicted as 14.

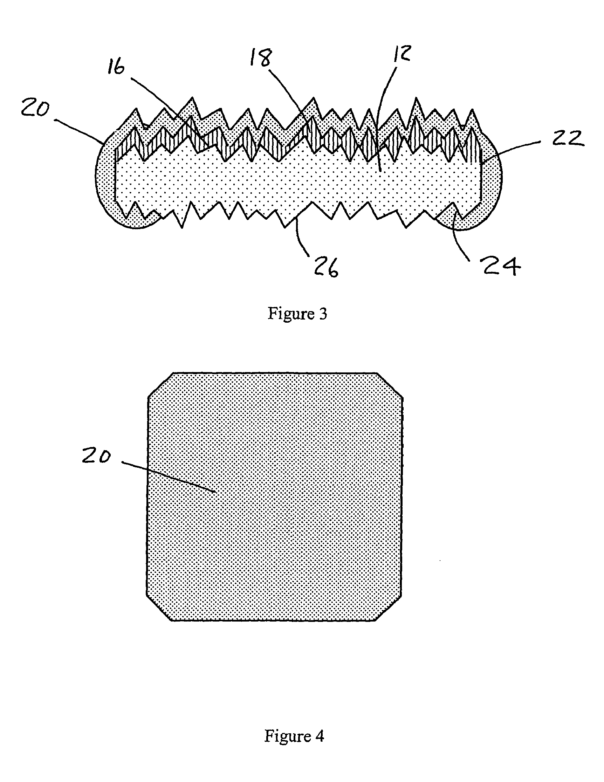

In Figure 3, a textured, n-doped first layer 18, formed by, for example, phosphorus diffusion, is present on the front surface 16, of the substrate 12, producing a p-n junction where the boron doped substrate 12 meets the n-doped layer 18. A second surface coating 20 is disposed over the first layer 18 of the cell on the edges 22, the front surface 16, and the periphery 24 of the back surface 26.

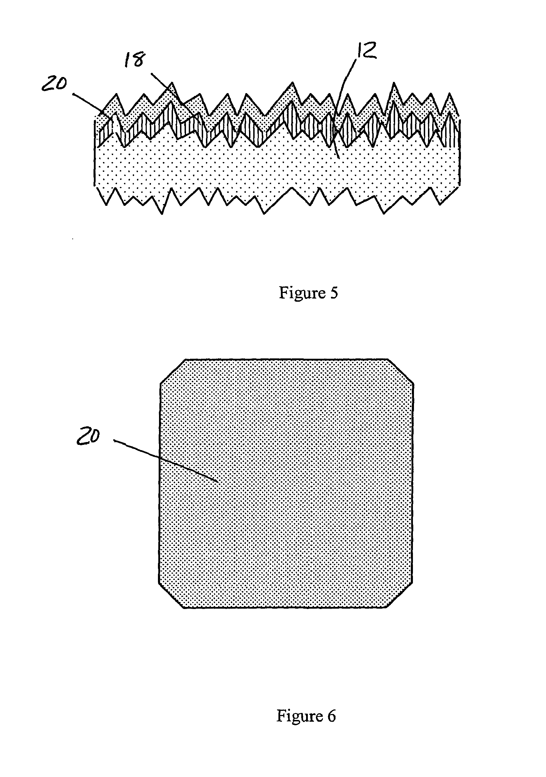

After forming the first layer 18, and second surface coating 20, the device 10 is cleaned and etched (see Figure 5) so as to remove unwanted parts of the coating 20.

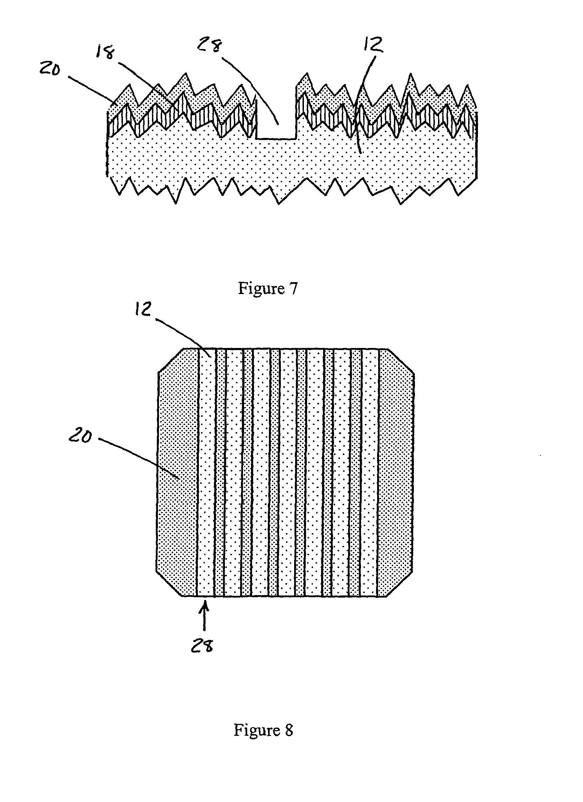

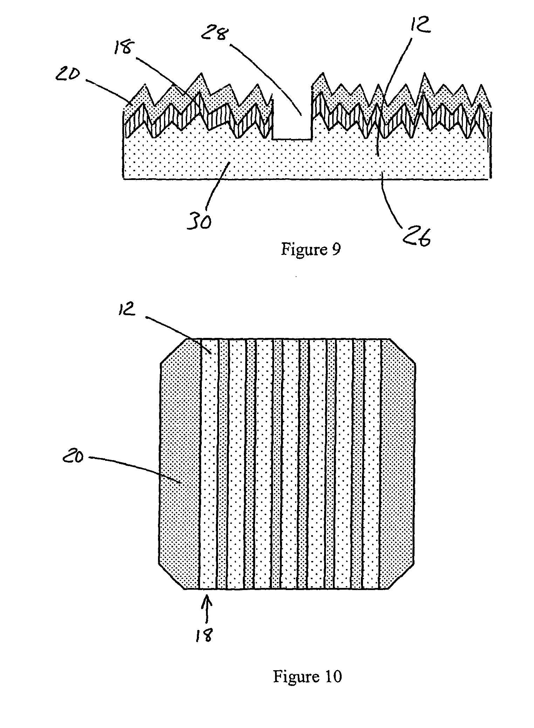

As shown in Figure 7, grooves 28 are formed in the substrate 12, through the layer 18 and surface coating 20. After forming the grooves 28, a cleaning process is undertaken so as to remove unwanted debris. Such cleaning polishes the back surface 26 of the device 10, and results in an untextured or substantially smooth back surface 30 as shown in Figure 9.

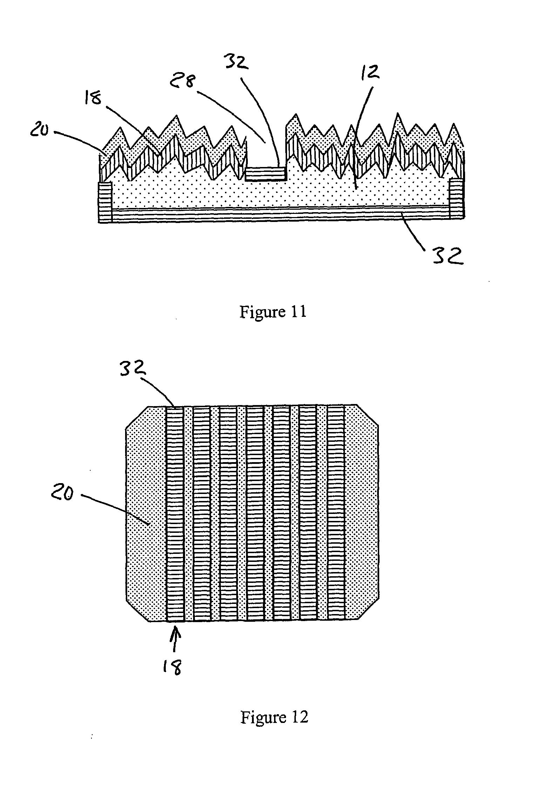

The grooves 28 (and in the present embodiment the back 26 of the substrate 12), are then doped to produce a third n-dopant layer 32 (see Figure 11). Any excess amounts of material may washed away.

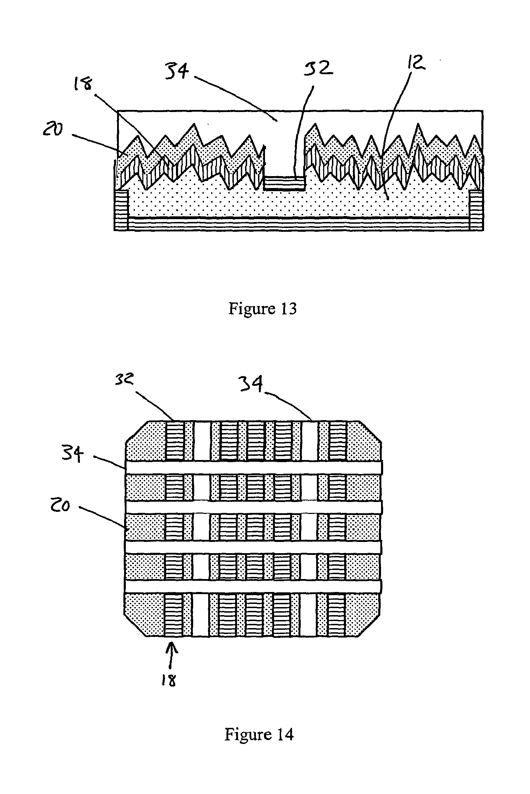

After application of the third layer 32, and as shown in Figure 13, a plurality of contact fingers 34 are printed onto the top surface of the device 10, such that contact fingers intercept the grooves, preferably at an angle of 90°.

Following formation of the contact fingers 34, a back surface field 36 is formed on the rear surface 26, the back surface field additionally comprising electrical contacts 38.

Lastly, and referring to Figure 18, the front and back surfaces of the device 10 are electronically isolated.

### Example of photovoltaic cell, and production thereof

### Starting Material

Use was made of conventional CZ silicon wafers doped p-type with boron to a resistivity of 1.2 ohm/cm and grown with [100] crystal planes parallel to the wafer surface. The wafer dimensions were 127 mm square with rounded corners of a diameter 150 mm. The wafer thickness was 300 µm. Such wafers are commercially available, for example from MSetek, PV Silicon GmbH, Advansil or Pillar.

### Wafer Surface Preparation

The wafers were anisotropically "texture" etched in a solution of sodium hydroxide (2%) and propanol (2%) at a temperature of 85°C and cleaned by subsequent immersions in hydrofluoric acid and hydrochloric acid with intermediate and final rinsing in deionized water followed by drying.

### Phosphorus Doping and Silicon Nitride Deposition

Wafers were placed in pairs (touching) in the slots in a quartz wafer carrier and treated in an atmosphere of POCl₃ vapour and oxygen at a temperature of 800°C to deposit a 10 nm thick film of phosphorus glass on the exterior surfaces. The wafers (in their quartz carrier) were then treated in an atmosphere of dichlorosilane and ammonia gases at a pressure of 40 Pa and a temperature between 780 and 860°C to deposit a 110 nm thick film of silicon nitride on the exterior silicon, and a resistivity of about 100 ohms/square.

### Plasma Etch

This is not an essential part of the process but is desirable for good cell results. As a consequence of the previous process, some unwanted silicon nitride is generally deposited around the perimeter of the rear of the wafer (to a distance of 10-20 mm). This film was removed by etching in a gas plasma formed with Freon 14 and an oxygen and nitrogen gas mixture. This was achieved by placing the wafers with their front surfaces touching each other and exposing the rear surfaces to the gas plasma.

### Groove Definition

A number of grooves were cut by laser ablation into the front surface (the surface with the silicon nitride film) that would subsequently form the conductive grid by which the electrical current is carried. Each groove had dimensions of typically 20 µm width and 35 µm depth and was formed by laser ablation of the surface material using an 8W 1064 nm Nd:Vanadate laser switched at approximately 150 kHz with pulse durations around 130 ns capable of focused spot sizes of approximately 10 µm traversing the wafer surface at a velocity of approximately 600 mm/s. The groove pattern comprised a first group of parallel lines at a pitch of 1.0 mm distributed over the entire cell surface.

### Groove Cleaning

The action of groove definition via laser grooving generally results in silicon debris on the wafer surface and groove sidewalls that contain undesirable crystal imperfections. Accordingly the wafers were etched in a solution of sodium hydroxide at 50°C for approximately 10 minutes to dissolve the debris and etch the groove walls to a depth of a few microns. The wafers were then cleaned by subsequent immersions in 4% hydrofluoric acid and 4% hydrochloric acid with intermediate and final rinsing in de-ionized water followed by drying.

### Groove Doping

The silicon wafers were placed in a quartz wafer carrier and inserted into a quartz tube where they were treated in an atmosphere of POCl₃ vapour and oxygen at a temperature of 960-1000°C for 20 minutes. Phosphorous doped the exposed silicon surfaces to a sheet resistivity of 6 - 8 ohms per square.

### Groove Doping Cleaning

Doped grooves were cleaned using a solution of 1% to 4% HF solution, in order to remove the byproduct thin film deposited during the previous doping step.

### Screen-print Finger Contacts

In order to establish a front electrical contact to the doped laser defined grooves, a silver (Ag) front metallization grid was screen printed with 51 conducting fingers 120 µm wide and 20 µm thick printed at 90° relative to the doped grooves. The number of conducting fingers of the front contact pattern may be between 20 and 70, but is preferably 51 for a 125x125mm device. The width of these fingers may be between 20µm and 150µm, preferably 80µm, while keeping the cross section of the conducting finger equivalent to the tested structure.

The fingers are connected amongst themselves by 2 conducting bus bars of 1.8mm width and 20 µm thick. These bus bars are generally less than 2 mm, and more than 0.5mm in width, preferably 1.5mm in width, whilst maintaining equivalent conduction cross-section. These bus bars are separated among themselves by 62.5 mm and are patterned orthogonal to the Ag fingers.

In the present embodiment of the process, the screen printed front contacts need to be dried at a maximum temperature of 350 °C for approximately 2 minutes. Other versions of this front metallization process can avoid such a drying step.

### Rear Contacts And Back Surface Field

Ohmic contact and back surface field formation at the back of the cell was achieved via screen printing. 2 Ag contact pad structures were screen printed on the back with contact pads 5 mm in width and 105 mm in length separated by 62.5 mm in pitch.

Their length was parallel to the front bus bar Ag pattern. Subsequently an Al screen pattern, negative to the back Ag contact pad structure, was printed producing a 1 mm overlap with the Ag contact pad structure, while maintaining a 2 mm edge exclusion zone near the edge of the cell. Subsequent back metallization drying, and front and back metallization co-firing, resulted in formation of the ohmic contacts (front and back) and Al back surface field. Maximum firing temperatures of the order of 900° C are typical.

### Edge Isolation

The undesired electrically conductive deposits on the edges were removed by cleaving and discarding the 1 mm silicon at the edge then removed the edge material.

The cell was now complete and ready for testing.

### Results

| Cell Type | Area (cm²) | Emitter (Ω/□) | Jsc (mAcm⁻²) | Voc (mV) | FF (%) | Eff (%) |
|---|---|---|---|---|---|---|
| Prior art laser grooved cell | 154 | >100 | 35 | 612 | 79 | 16.8 |
| Cell according to the present invention | 154 | >100 | 38 | 635 | 76⁽¹⁾ | 18.3 |
| Cell according to: US2005/0074917 | - | - | - | 615 | 78.7 | 17.8 |
| Suntech Standard Screen Print Cell | 150 | 50 | 35.1 | 614 | 76.3 | 16.5 [VU1] |

| | | | | | | |
|---|---|---|---|---|---|---|
| ⁽¹⁾ Further optimization to raise FF ongoing. Note: - Jsc = Short Circuit Current Density - Voc = Open Circuit Voltage - FF = Fill Factor - Eff = Cell Efficiency | | | | | | |

## Claims

1. A process for producing a photovoltaic device having a substrate comprising silicon doped with a first dopant, the process comprising the steps of:
a. forming a first layer over a front surface of the substrate, the first layer comprising a second dopant of a conductivity type opposite the first dopant;
g. forming a second surface coating over the first layer;
h. forming elongate grooves reaching or entering the silicon substrate;
i. forming a third layer within the grooves, the layer comprising a third dopant of a conductivity type opposite to the first dopant;
j. forming a contact finger system which intersects with the grooves to provide an electrically conducting front contact; and
k. forming a second contact.

2. A process according to Claim 1, wherein the substrate is textured prior to step (a).

3. A process according to Claim 1 or Claim 2, wherein the second surface coating acts as one or more of a dielectric layer, anti-reflective coating, surface passivator, bulk passivator, diffusion mask and/or metallization diffusion barrier.

4. A process according to any one of the preceding claims, wherein the second surface layer is applied by low pressure chemical vapour deposition.

5. A process according to any one of the preceding claims, wherein the second surface layer is silicon nitride.

6. A process according to any one of the preceding claims, wherein after step (b) any second surface coating is removed from the rear surface.

7. A process according to any one of the preceding claims, wherein the grooves are of uniform dimension along their length.

8. A process according to any one of the preceding claims, wherein after step (c) the grooves are cleaned.

9. A process according to any one of the preceding claims, wherein after step (c) the back surface is additionally polished.

10. A process according to any one of the preceding claims, wherein after step (d) excess amounts of the third layer material are removed.

11. A process according to any preceding claim, wherein the contact fingers are orthogonal to the grooves.

12. A process according to any preceding claim, wherein the contact fingers are silver.

13. A process according to any one of the preceding claims, wherein step (f) comprises forming a back surface field.

14. A process according to Claim 10, wherein a layer of aluminum is deposited on a rear surface of the device and cured.

15. A process according to Claim 11, wherein the aluminium layer comprises contact pads.

16. A process according to Claim 12, wherein the contact pads are silver.

17. A process according to any one of the preceding claims, wherein after formation of the substrate, the edges of the wafer are electronically isolated.

18. A photovoltaic produced by a process in accordance with any one of the preceding claims.

19. A photovoltaic device comprising:
a. first layer formed over a front surface of the substrate, the first layer comprising a second dopant of a conductivity type opposite the first dopant;
b. a second surface coating formed over the first layer;
c. plurality of elongate grooves formed in a front surface of the device, such that the grooves reach or enter the silicon substrate;
d. a third layer formed within the grooves, the layer comprising a third dopant of a conductivity type opposite the first dopant;
e. a contact finger system which intersects with the grooves to provide an electrically conducting front contact; and
f. a second contact.
